# EUROPÄISCHE PATENTSCHRIFT

(11) **EP 1 483 828 B1**
(45) Veröffentlichungstag und Bekanntmachung des Hinweises auf die Patenterteilung: **20.07.2005**
(21) Anmeldenummer: 03714690.9
(22) Anmeldetag: 11.03.2003
(51) Int. Cl.: H03C 3/40, H03C 3/09

(54) **SENDEANORDNUNG FÜR FREQUENZMODULATION**
TRANSMITTER ARRANGEMENT FOR FREQUENCY MODULATION
DISPOSITIF EMETTEUR DESTINE A LA MODULATION DE FREQUENCE

(30) Priorität: 14.03.2002 DE 10211381
(43) Veröffentlichungstag der Anmeldung: 08.12.2004
(73) Patentinhaber: Infineon Technologies AG, 81669 München (DE)
(72) Erfinder: GREWING, Christian, 40489 Düsseldorf (DE); HAMMES, Markus, 46539 Dinslaken (DE); HANKE, André, 40489 Düsseldorf (DE); VAN WAASEN, Stefan, 19248 Sollentuna (SE)
(74) Vertreter: Epping Hermann & Fischer
(86) Internationale Anmeldenummer: PCT/DE2003/000773
(87) Internationale Veröffentlichungsnummer: WO 2003/079536

(56) Entgegenhaltungen:
- EP-A- 1 063 766
- WO-A-95/16304
- US-A- 4 449 250
- US-A- 4 994 768

## Beschreibung

Die vorliegende Erfindung betrifft eine Sendeanordnung für Frequenzmodulation.

Normalerweise wird zur Modulation einer Trägerfrequenz in einer Sendeanordnung mit einem Frequenzmodulationsverfahren ein als Vektormodulator ausgebildeter Quadraturmodulator oder IQ-Modulator eingesetzt. Dabei wird üblicherweise das eigentliche, die Modulationsdaten enthaltende Sendesignal in einer digitalen Signalverarbeitung auf einer Zwischenfrequenz erzeugt, die gering ist oder verschwindet. Entsprechende Sendestrukturen werden als Low-IF- oder Zero-IF-Sender bezeichnet. Dabei ist IF eine Abkürzung für die Zwischenfrequenz, Intermediate Frequency. Mit dem als Doppelmischer ausgebildeten IQ-Mischer wird dieses modulierte Signal als Einseitenband-Signal auf die gewünschte Trägerfrequenz hochgesetzt. Bei einem derartigen Quadraturmodulator muß sowohl das die eigentlichen Modulationsdaten enthaltende Modulationssignal, als auch das Trägersignal zerlegt in Quadraturkomponenten vorliegen. Quadraturkomponenten werden auch als IQ-Komponenten bezeichnet. Inphase- und Quadraturkomponente stehen dabei orthogonal zueinander und bilden ein komplexwertiges Signal.

Zur Regelung der Sendefrequenz ist üblicherweise eine Regelschleife in Form einer Phasenregelschleife, Phase Locked Loop, PLL in der Sendearchitektur vorgesehen (siehe z.B. das Dokument US 4 449 250 A). Eine derartige PLL umfaßt beispielsweise einen Phasendetektor, ein Schleifenfilter, eine Ladungspumpe, einen spannungsgesteuerten Oszillator und einen Frequenzteiler, die entsprechend miteinander verschaltet sind. Um zu verhindern, daß niederfrequente Anteile des Modulationssignals von der Phasenregelschleife weggeregelt werden, wird normalerweise das unmodulierte Trägersignal, nicht das modulierte Ausgangssignal der Sendeanordnung in die Phasenregelschleife zur Frequenzregelung eingespeist.

Das beschriebene Prinzip hat jedoch den Nachteil, daß bei einer Modulation eines Frequenzanteils vor der Frequenzumsetzung des Oszillatorsignals auf die Sendefrequenz nur ein unmodulierter Frequenzanteil, also nicht die Endfrequenz oder Ausgangsfrequenz des Senders, in die Phasenregelschleife eingespeist werden kann.

Aufgabe der vorliegenden Erfindung ist es, eine Sendeanordnung anzugeben, bei der niederfrequente Anteile der Modulation in der Phasenregelung berücksichtigt werden, um ein Wegdriften der Kanalfrequenz des Senders zu verhindern, und welche zugleich gute Rauscheigenschaften aufweist.

Erfindungsgemäß wird die Aufgabe gelöst durch eine Sendeanordnung für Frequenzmodulation, aufweisend
- einen ersten Eingangsanschluß zum Zuführen von Modulationsdaten,
- einen zweiten Eingangsanschluß zum Zuführen eines Signals zur Kanalvorwahl,
- einen Aufwärts-Frequenzmischer mit einem ersten Eingang, der mit dem ersten Eingangsanschluß zum Zuführen von Modulationsdaten gekoppelt ist,
- ein Verknüpfungsglied mit zwei Eingängen, die mit dem ersten und dem zweiten Anschluß der Sendeanordnung gekoppelt sind, und mit einem Ausgang und
- eine Phasenregelschleife, umfassend
   einen Oszillator mit einem Steuereingang zum Steuern der Ausgangsfrequenz, der einen Ausgang hat, der mit einem zweiten Eingang des Aufwärts-Frequenzmischers verbunden ist,
   den Aufwärts-Frequenzmischer, und
   einen Rückkopplungspfad, der an einen Ausgang des Aufwärts-Frequenzmischers sowie an einen Eingang eines Phasenvergleichers angeschlossen ist und der einen Frequenzteiler umfaßt, mit einem Steuereingang, der an den Ausgang des Verknüpfungsgliedes gekoppelt ist,
wobei der Phasenvergleicher einen Ausgang hat, der mit dem Steuereingang des Oszillators gekoppelt ist.

Gemäß dem vorliegenden Prinzip wird das modulierte Sendesignal, welches am Ausgang des Aufwärts-Frequenzmischers bereitsteht, in die Phasenregelschleife eingespeist. Somit wird ein Wegdriften der Kanalfrequenz durch niederfrequente Anteile im Niedermodulationssignal verhindert, da eine Kompensationseinrichtung dadurch gebildet ist, daß die Modulationsdaten nicht nur dem Aufwärts-Frequenzmischer zugeführt werden, sondern auch dem Frequenzteiler im Rückkopplungspfad der Regelschleife. Der Frequenzteiler bewirkt in Kombination mit der Phasenregelschleife wie bei einer herkömmlichen Sendeanordnung zusätzlich die Kanalvorwahl des Senders dadurch, daß das Signal zur Kanalvorwahl ebenfalls dem Frequenzteiler zugeführt wird.

Die Besonderheit des vorliegenden Prinzips ist unter anderem, daß der Aufwärts-Frequenzmischer, der als Modulator arbeitet, in die Regelschleife miteinbezogen ist und damit Rauschanteile und Störfrequenzanteile, welche im Aufwärts-Frequenzmischer entstehen und unerwünscht sind, weitgehend gedämpft werden.

Insbesondere solche Störfrequenzanteile, welche nahe an der Trägerfrequenz liegen und damit mittels Filteranordnungen kaum unterdrückt werden können, werden vorteilhafterweise mittels der Phasenregelschleife weggeregelt. Die beschriebene Sendeanordnung zeichnet sich durch einen geringen Strombedarf und gute Rauscheigenschaften aus.

Um hochfrequente Anteile des Modulationssignals zu berücksichtigen, ist der Frequenzteiler mit Vorteil als Fractional N-Frequenzteiler ausgebildet. Fractional N-Frequenzteiler bewirken eine Division des rückgekoppelten Signals in der Regelschleife nicht nur mittels ganzzahliger Werte, sondern mit beliebig einstellbaren Bruchzahlen.

Mit Vorteil ist der Aufwärts-Frequenzmischer als IQ-Mischer ausgelegt, der zur Verarbeitung eines komplexwertigen Modulationssignals ausgelegt ist. Ein komplexwertiges Modulationssignal ist zerlegt in eine Inphase-Komponente und eine dazu orthogonal stehende Quadratur-Komponente.

Der IQ-Mischer ist bevorzugt als Vektormodulators ausgebildet.

Da der Frequenzhub der Modulation bei einem IQ-Mischer beziehungsweise Vektormodulator nicht von Prozeßschwankungen bei der Herstellung integrierter Schaltungen abhängig ist, bedarf es gemäß dem vorliegenden Prinzip keines Abgleichs der Modulationskompensation in der Phasenregelschleife.

Die Modulationsdaten können bevorzugt als digital codierte, zu sendende Daten vorliegen. Das digitale Modulationssignal kann gemäß einer bevorzugten Weiterbildung des vorliegenden Prinzips zunächst mittels eines Digital-/Analog-Wandlers in ein entsprechendes analoges Signal konvertiert werden. Dem DA-Wandler ist mit Vorteil ein Tiefpaßfilter nachgeschaltet, welches bezüglich des an das Tiefpaßfilter am Ausgang angeschlossenen Aufwärts-Frequenzmischers als Anti-Aliasing-Filter wirkt.

Zur Kopplung des Modulationsdaten-Eingangsanschlusses mit dem digitalen Eingang des D-/A-Wandlers ist bevorzugt ein digitaler Frequenzmodulator vorgesehen, der an seinem Ausgang in Abhängigkeit von an seinem Eingang anliegenden Modulationsdaten ein digital codiertes, frequenzmoduliertes Signal bereitstellt.

Zwischen den Ausgang des Verknüpfungsgliedes und den Steuereingang des Frequenzteilers ist bevorzugt ein digitaler Delta-Sigma-Modulator geschaltet. Somit ist die Phasenregelschleife in Kombination mit der bevorzugten Ausführung des Frequenzteilers als Fractional-N Teiler mit Vorteil zu einer Delta-Sigma-Fractional-N-PLL weitergebildet.

In Alternative zu den beschriebenen, vorteilhaften Ausgestaltungen des erfindungsgemäßen Prinzips kann die Sendeanordnung gemäß dem vorliegenden Prinzip auch mit einer Sendearchitektur mit Zwischenfrequenz ausgebildet sein. In diesem Fall stellt der Oszillator der Phasenregelschleife nicht ein Signal bei der Sendefrequenz bereit, sondern ein Signal mit einer Frequenz, welches durch Mischen mit der Zwischenfrequenz gerade die gewünschte Sendefrequenz ergibt.

Weitere Einzelheiten und vorteilhafte Ausgestaltungen des vorliegenden Prinzips sind Gegenstand der abhängigen Ansprüche.

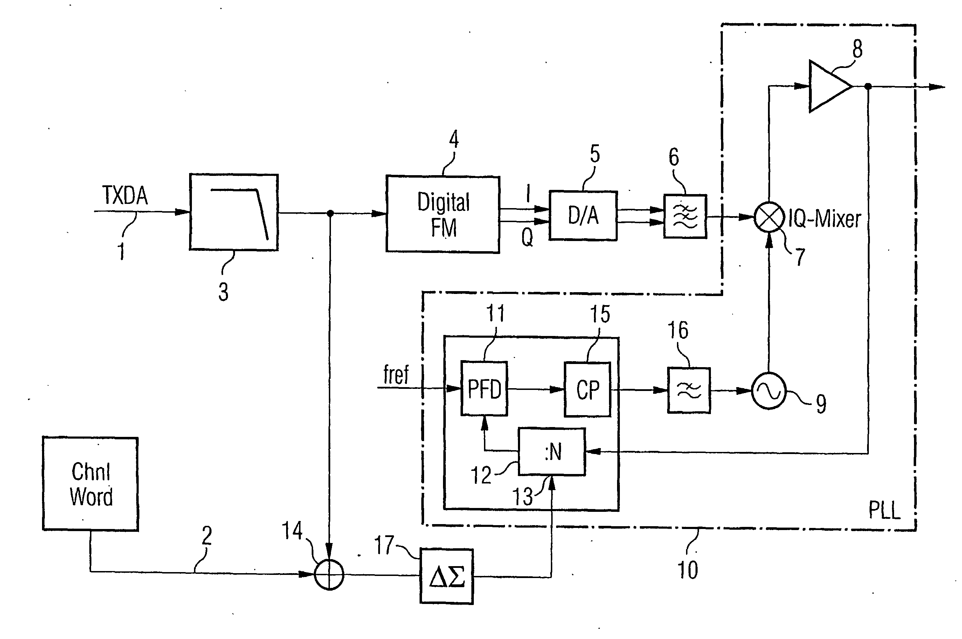

Die Erfindung wird nachfolgend an einem Ausführungsbeispiel anhand der einzigen Figur näher erläutert.

Es zeigt:
- die Figur: eine beispielhafte Ausführungsform des vorliegenden erfindungsgemäßen Prinzips anhand eines vereinfachten Blockschaltbildes.

Die Figur zeigt eine Sendeanordnung, welche für die Frequenzmodulation geeignet ist. Diese umfaßt einen ersten Eingangsanschluß 1 zum Zuführen von Modulationsdaten und einen zweiten Eingangsanschluß 2 zum Zuführen eines Signals zur Kanalvorwahl. Die beiden Eingangsanschlüsse 1, 2 sind ausgelegt zum Zuführen jeweiliger, digital codierter Daten. An den ersten Eingangsanschluß 1 ist ein digitales Filter 3 zur Aufbereitung der Modulationsdaten vorgesehen. An einen Ausgang des digitalen Filters 3 ist ein digitaler Frequenzmodulator 4 angeschlossen, dem an seinem Eingang die aufbereiteten Modulationsdaten zugeführt werden und an dessen Ausgang ein von den Modulationsdaten abgeleitetes Modulationssignal, welches digital codiert ist, ableitbar ist. Der Ausgang des digitalen Frequenzmodulators 4 ist als komplexwertiger Ausgang zur Ableitung orthogonaler Signalkomponenten ausgeführt, umfassend einen Inphase- und einen Quadraturausgang. Diese Ausgänge sind über einen Inphase- und einen Quadratursignalpfad I, Q an je einen Eingang eines je eines Digital-/Analogwandlers 5 angeschlossen, die das digital codierte Modulationssignal in ein entsprechendes, analoges Modulationssignal konvertieren. Ausgangsseitig an den D-/A-Wandlern 5 ist je ein Anti-Aliasing-Filter 6 angeschlossen. Der Ausgang des als Tiefpaßfilter ausgeführten Anti-Aliasing-Filters 6 ist mit einem ersten Eingang eines Aufwärts-Frequenzmischers 7 verbunden, der als Vektormodulator ausgebildet ist. Das Anti-Aliasing-Filter 6 kann alternativ, beispielsweise bei Ausführung des Senders mit von Null verschiedener Zwischenfrequenz auch als Bandpaß-Filter oder als Polyphasenfilter ausgebildet sein. An einen Ausgang des IQ-Mischers 7 ist ein Vorverstärker 8 angeschlossen, dessen Ausgang den Ausgang der Sendeanordnung bildet. Ein zweiter Eingang des Aufwärts-Frequenzmischers 7, der als IQ-Mischer ausgeführt ist, ist an den Ausgang eines spannungsgesteuerten Oszillators 9 angeschlossen, der ein hochfrequentes Trägersignal bei der gewünschten Sendefrequenz zerlegt in orthogonale Signalkomponenten bereitstellt. Sowohl der spannungsgesteuerte Oszillator 9, als auch der IQ-Mischer 7 sind in einer Phasenregelschleife 10 angeordnet. Diese Phasenregelschleife 10 umfaßt einen Rückkopplungspfad, der den Ausgang des Verstärkers 8 und damit den Ausgang des Aufwärts-Frequenzmischers 7 mit einem Phasendetektor 11 an einem ersten Eingang desselben koppelt. Der Rückkopplungspfad der Phasenregelschleife 10 weist dabei zur Kopplung des Verstärkers 8 mit dem Phasendetektor 11 einen Frequenzteiler 12 auf, der als Fractional N-Teiler ausgebildet ist und einen Steuereingang 13 aufweist, an dem in digital codierter Form ein Frequenzteilerverhältnis zuführbar ist. Der Steuereingang 13 des Fractional-N-Frequenzteilers 12 ist mit dem Ausgang eines Verknüpfungsgliedes 14 über einen Sigma-Delta-Modulator 17, der in alternativen Ausführungen auch entfallen kann, verbunden. Das Verknüpfungsglied 14 hat zwei Eingänge, die mit dem ersten Eingangsanschluß und dem zweiten Eingangsanschluß 1, 2 der Sendeanordnung gekoppelt sind. Das Verknüpfungsglied 14 verknüpft demnach die als digitale Daten vorliegenden Modulationsdaten mit dem ebenfalls digital vorliegenden Signal zur Kanalvorwahl und führt dieses verknüpfte, ebenfalls digital codierte Signal oder ein davon abgeleitetes Signal dem Steuereingang des Frequenzteilers 12 zu. Ein zweiter Eingang des Phasendetektors 11 ist mit einer hier nicht dargestellten Bezugsfrequenzquelle zur Zuführung eines Signals mit einer Referenzfrequenz gekoppelt. Der Ausgang des Phasendetektors 11, der als Phasen- und Frequenzdetektor ausgebildet ist, ist über eine Ladungspumpenschaltung 15 und ein Schleifenfilter 16 mit dem Steuereingang des spannungsgesteuerten Oszillators 9 verbunden.

Die Figur zeigt eine homodyne Sendeanordnung mit einer Direktumsetzung, welche für frequenzmodulierte Signal geeignet ist, und mit einer Phasenregelschleife 10. Die Sendeanordnung entspricht dabei einer Weiterbildung des 2-Punkt-Modulationsprinzips einer Phasenregelschleife.

Gemäß der Figur werden Modulationsdaten in ein Modulationssignal gewandelt und einem Aufwärts-Mischer 7 zugeführt. Zusätzlich werden zu Kompensationszwecken die Modulationsdaten auch einem Frequenzteiler 12 im Rückkopplungspfad der PLL 10 zugeführt. Die Besonderheit des vorliegenden Prinzips ist dabei, daß der Aufwärts-Frequenzmischer 7 vollständig in die Phasenregelung integriert ist. Somit können mit Vorteil Rausch- und Störfrequenzanteile, die im Mischer 7 entstehen, in einfacher Weise gedämpft werden, soweit sie innerhalb der Bandbreite der Regelschleife 10 liegen. Ein Wegdriften der Kanalfrequenz durch niederfrequente Anteile des Modulationssignals wird durch die Kompensation mittels des Frequenzteilers 12, dem die Modulationsdaten ebenfalls zugeführt werden, erreicht.
Der Vektormodulator 7 benötigt mit Vorteil keine Abgleichmaßnahmen. Es ist kein Abgleich der erfindungsgemäßen Modulationskompensation erforderlich, da der Frequenzhub des Modulationssignals bei einem Vektormodulator nicht von Prozeßschwankungen bei der Fertigung der Sendeanordnung abhängig ist.

Da in modernen Sendearchitekturen ohnehin üblicherweise eine Fractional N-PLL 12, bevorzugt in Kombination mit einem Delta-Sigma-Modulator 17, eingebaut ist, um kurze Einschwingzeiten der Regelschleife zu erzielen, ist das beschriebene Prinzip mit geringem zusätzlichem Aufwand realisierbar.

Anstelle der gezeigten Ausführung mit einer Direktumsetzung ist das vorliegende Prinzip im Rahmen der Erfindung auch auf heterodyne Sendearchitekturen, die mit einer Zwischenfrequenzebene von beispielsweise von einigen 100 MHz arbeiten, anwendbar. Ebenso kann das beschriebene Prinzip bei Low-IF- und Zero-IF-Sendestrukturen zum Einsatz kommen.

Bei einer Zwischenfrequenz von beispielsweise einigen 100 Megahertz kann dabei bevorzugt eine Frequenzmodulation analog durchgeführt werden, um für hochfrequente Signale ausgelegte Digital/Analog-Wandler zu umgehen.

### Bezugszeichenliste

- 1: Modulationseingang
- 2: Kanalvorwahl-Eingang
- 3: Digitalfilter
- 4: Digitaler Frequenzmodulator
- 5: D-/A-Wandler
- 6: Tiefpaßfilter
- 7: Aufwärts-Frequenzmischer
- 8: Verstärker
- 9: VCO
- 10: PLL
- 11: Phasendetektor
- 12: Fractional N-Frequenzteiler
- 13: Steuereingang
- 14: Verknüpfungsglied
- 15: Ladungspumpe
- 16: Schleifenfilter
- 17: Delta-Sigma-Modulator

## Patentansprüche

1. Sendeanordnung für Frequenzmodulation, aufweisend
- einen ersten Eingangsanschluß (1) zum Zuführen von Modulationsdaten,
- einen zweiten Eingangsanschluß (2) zum Zuführen eines Signals zur Kanalvorwahl,
- einen Aufwärts-Frequenzmischer (7) mit einem ersten Eingang, der mit dem ersten Eingangsanschluß (1) zum Zuführen von Modulationsdaten gekoppelt ist,
- ein Verknüpfungsglied (14) mit zwei Eingängen, die mit dem ersten und dem zweiten Anschluß (1, 2) der Sendeanordnung gekoppelt sind, und mit einem Ausgang und
- eine Phasenregelschleife (10), umfassend einen Oszillator (9) mit einem Steuereingang zum Steuern der Ausgangsfrequenz des Oszillators (9), der einen Ausgang hat, der mit einem zweiten Eingang des Aufwärts-Frequenzmischers (7) verbunden ist,
den Aufwärts-Frequenzmischer (7), und
einen Rückkopplungspfad, der an einen Ausgang des Aufwärts-Frequenzmischers (7) sowie an einen Eingang eines Phasenvergleichers (11) angeschlossen ist und der einen Frequenzteiler (12) umfaßt, mit einem Steuereingang (13), der mit dem Ausgang des Verknüpfungsgliedes (14) gekoppelt ist,
wobei der Phasenvergleicher (11) einen Ausgang hat, der mit dem Steuereingang des Oszillators (9) gekoppelt ist.

2. Sendeanordnung nach Anspruch 1,
**dadurch gekennzeichnet, daß**
der Frequenzteiler (13) ausgelegt ist zur Frequenzteilung mit Bruchzahlen.

3. Sendeanordnung nach Anspruch 1 oder 2,
**dadurch gekennzeichnet, daß**
der Aufwärts-Frequenzmischer (7) ausgelegt ist zur Verarbeitung eines komplexwertigen, in Inphase- und Quadraturkomponente zerlegten Modulationssignals.

4. Sendeanordnung nach einem der Ansprüche 1 bis 3,
**dadurch gekennzeichnet , daß**
zur Kopplung des ersten Eingangsanschlusses (1) der Sendeanordnung mit dem ersten Eingang des Aufwärts-Frequenzmischers (7) ein Digital-/Analog-Wandler (5) mit nachgeschaltetem Tiefpaßfilter (6) vorgesehen ist.

5. Sendeanordnung nach Anspruch 4,
**dadurch gekennzeichnet, daß**
zur Kopplung des ersten Eingangsanschlusses (1) der Sendeanordnung mit einem Eingang des Digital-/Analog-Wandlers (5) ein digitaler Frequenzmodulator (4) vorgesehen ist, der in Abhängigkeit von den Modulationsdaten ein frequenzmoduliertes Signal bereitstellt.

6. Sendenanordnung nach einem der Ansprüche 1 bis 5,
**dadurch gekennzeichnet , daß**
die Phasenregelschleife (10) zur Kopplung des Phasenvergleichers (11) mit dem gesteuerten Oszillator (9) eine Ladungspumpenschaltung (15) mit nachgeschaltetem Schleifenfilter (16) umfaßt.

7. Sendeanordnung nach einem der Ansprüche 1 bis 6
**dadurch gekennzeichnet , daß**
der Phasenvergleicher (11) einen weiteren Eingang hat, der mit einem Bezugsfrequenzgenerator verbunden ist.

8. Sendeanordnung nach einem der Ansprüche 1 bis 7
**dadurch gekennzeichnet, daß**
ein Delta-Sigma-Modulator (17) vorgesehen ist, mit einem Eingang, der an den Ausgang des Verknüpfungsgliedes (14) angeschlossen ist, und mit einem Ausgang, der an den Steuereingang (13) des Frequenzteilers (12) angeschlossen ist.

## Claims

1. A transmission arrangement for frequency modulation, having
- a first input connection (1) for supplying modulation data,
- a second input connection (2) for supplying a channel preselection signal,
- a step-up frequency mixer (7) having a first input, which is coupled to the first input connection (1), for supplying modulation data,
- a logic linking element (14) having two inputs, which are coupled to the first and second connections (1, 2) of the transmission arrangement, and an output, and
- a phase locked loop (10) comprising
an oscillator (9) having a control input for controlling the output frequency of the oscillator (9), and an output which is connected to a second input of the step-up frequency mixer (7),
the step-up frequency mixer (7), and
a feedback path which is connected to an output of the step-up frequency mixer (7) and to an input of a phase comparator (11), and comprises a frequency divider (12) having a control input (13) which is coupled to the output of the logic linking element (14),
with the phase comparator (11) having an output which is coupled to the control input of the oscillator (9).

2. The transmission arrangement as claimed in claim 1,
wherein
the frequency divider (13) is designed to divide the frequency using fractions.

3. The transmission arrangement as claimed in claim 1 or 2,
wherein
the step-up frequency mixer (7) is designed to process a complex modulation signal which has been broken down into an in-phase component and a quadrature component.

4. The transmission arrangement as claimed in one of claims 1 to 3,
wherein
a digital/analog converter (5) with a downstream lowpass filter (6) is provided for the purpose of coupling the first input connection (1) of the transmission arrangement to the first input of the step-up frequency mixer (7).

5. The transmission arrangement as claimed in claim 4,
wherein
a digital frequency modulator (4) which produces a frequency-modulated signal as a function of the modulation data is provided for the purpose of coupling the first input connection (1) of the transmission arrangement to an input of the digital/analog converter (5).

6. The transmission arrangement as claimed in one of claims 1 to 5,
wherein
the phase locked loop (10) has a charge pump circuit (15) with a downstream loop filter (16) for the purpose of coupling the phase comparator (11) to the controlled oscillator (9).

7. The transmission arrangement as claimed in one of claims 1 to 6,
wherein
the phase comparator (11) has a further input which is connected to a reference frequency generator.

8. The transmission arrangement as claimed in one of claims 1 to 7,
wherein
a delta-sigma modulator (17) is provided, said modulator having an input, which is connected to the output of the logic linking element (14), and an output which is connected to the control input (13) of the frequency divider (12).

## Revendications

1. Dispositif émetteur pour la modulation de fréquence comportant
- une première borne (1) d'entrée pour l'entrée de données de modulation ;
- une deuxième borne (2) d'entrée pour l'entrée d'un signal de présélection de canal ;
- un mélangeur (7) de fréquence élévateur ayant une première entrée qui est couplée à la première borne (1) d'entrée pour l'entrée de données de modulation ;
- un élément (14) de combinaison ayant deux entrées qui sont couplées à la première et à la deuxième bornes (1, 2) du dispositif émetteur et ayant une sortie ; et
- une boucle (10) à verrouillage de phase comprenant
un oscillateur (9) ayant une entrée de commande de la fréquence de sortie de l'oscillateur (9) qui a une sortie qui est reliée à une deuxième entrée du mélangeur (7) de fréquence élévateur ; et
un trajet de réaction qui est raccordé à une sortie du mélangeur (7) de fréquence élévateur ainsi qu'à une entrée d'un comparateur (11) de phase et qui comporte un diviseur (12) de fréquence ayant une entrée (13) de commande qui est couplée à la sortie de l'élément (14) de combinaison,
dans lequel le comparateur (11) de phase a une sortie qui est couplée à l'entrée de commande de l'oscillateur (9).

2. Dispositif émetteur suivant la revendication 1,
**caractérisé en ce que**
le diviseur (13) de fréquence est conçu pour la division de fréquence par un nombre fractionnaire.

3. Dispositif émetteur suivant la revendication 1 ou 2,
**caractérisé en ce que** le mélangeur (7) de fréquence élévateur est conçu pour le traitement d'un signal de modulation de valeur complexe décomposé en une composante en phase et en une composante en quadrature.

4. Dispositif émetteur suivant l'une des revendications 1 à 3,
**caractérisé en ce qu'**il est prévu pour le couplage de la première borne (1) d'entrée du dispositif émetteur à la première entrée du mélangeur (7) de fréquence élévateur un convertisseur (5) numérique/analogique ayant un filtre (6) passe-bas en aval.

5. Dispositif émetteur suivant la revendication 4,
**caractérisé en ce qu'**il est prévu, pour le couplage de la première borne (1) d'entrée du dispositif émetteur à une entrée du convertisseur (5) numérique/analogique, un modulateur (4) de fréquence numérique qui donne, en fonction des données de modulation, un signal modulé en fréquence.

6. Dispositif émetteur suivant l'une des revendications 1 à 5,
**caractérisé en ce que** la boucle (10) à verrouillage de phase comprend pour le couplage du comparateur (11) de phase à l'oscillateur (9) commandé un circuit (15) de pompe de charge ayant un filtre (16) à boucle en aval.

7. Dispositif émetteur suivant l'une des revendications 1 à 6,
**caractérisé en ce que** le comparateur (11) de phase a une autre entrée qui est reliée à un générateur d'une fréquence de référence.

8. Dispositif émetteur suivant l'une des revendications 1 à 7,
**caractérisé en ce qu'**il est prévu un modulateur (17) delta-sigma ayant une entrée qui est raccordée à la sortie de l'élément (14) de combinaison et ayant une sortie qui est raccordée à l'entrée (13) de commande du diviseur (12) de fréquence.
